# EUROPEAN PATENT APPLICATION

(11) **EP 4 123 694 A1**
(43) Date of publication of application: **25.01.2023**
(21) Application number: 21187116.5
(22) Date of filing: 22.07.2021
(51) Int. Cl.: H01L 21/822, H01L 21/8238, H01L 27/06, H01L 27/092, H01L 29/423

(54) **A SEMICONDUCTOR STRUCTURE WITH AN EPITAXIAL LAYER STACK FOR FABRICATING BACK-SIDE CONTACTS**

(71) Applicant: Imec VZW, 3001 Leuven (BE)
(72) Inventor: Hiblot, Gaspard, 3000 Leuven (BE); Hellings, Geert, 1500 Halle (BE); Van der Plas, Geert, 3000 Leuven (BE)
(74) Representative: Roth, Sebastian

(57) **Abstract**

The present disclosure relates to the fabrication of back-side devices on a back-side of a (thin) semiconductor layer, wherein the semiconductor layer also comprises one or more front-side logic devices arranged on its front-side. The disclosure presents a semiconductor structure that comprises the semiconductor layer (21), and the one or more front-side logic devices (22), which are at least partly arranged in a front-side of the semiconductor layer. Further, the semiconductor structure comprises at least four epitaxial layers (23) arranged on a back-side of the semiconductor layer, wherein the four epitaxial layers comprise a first epitaxial layer (23a) of a first conductivity type, a second epitaxial layer (23b) of a second conductivity type provided directly on the first epitaxial layer, a third epitaxial layer (23c) of the second conductivity type provided directly on the second epitaxial layer, and a fourth epitaxial layer (23d) of the first conductivity type provided directly on the third epitaxial layer. Further, the semiconductor structure comprises a plurality of the back-side contacts (24), which are exposed at a back-side surface of the fourth epitaxial layer, and are processed into different depths of the at least four epitaxial layers.

## Description

### TECHNICAL FIELD

The present disclosure relates to the fabrication of back-side contacts on a back-side of a (thin) semiconductor layer, wherein the semiconductor layer also comprises front-side logic devices arranged on its front-side. The disclosure presents, in particular, a semiconductor structure that includes the semiconductor layer, the front-side logic devices, and the back-side contacts. The back-side contacts are formed in an epitaxial layer stack of four or more epitaxial layers. The disclosure also provides a device, which includes the semiconductor structure and additionally back-side semiconductor devices coupled to the back-side contacts of the semiconductor structure.

### BACKGROUND OF THE INVENTION

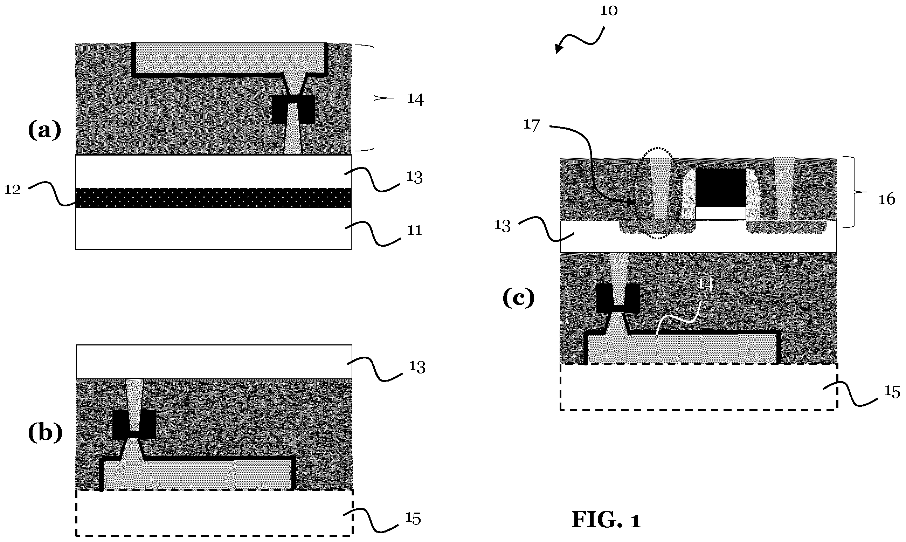

Extreme thinning of a semiconductor substrate (or layer), for instance, using an etch stop layer, may be explored to fabricate back-side semiconductor devices on the semiconductor substrate. For instance, this technique maybe used to fabricate a back-side Power Distribution Network (PDN) for front-side logic devices, wherein the PDN includes the back-side semiconductor devices. The technique opens up many new system and processing possibilities. FIG. 1 shows an example of a device 10 that is fabricated using this technique.

FIG. 1 shows specifically in (a), that a silicon substrate 11 is provided, and a silicon germanium etch stop layer 12 is formed on the silicon substrate 11. Further, a silicon layer 13 is formed on the etch stop layer 12, and a plurality of front-side logic devices 14 are formed on the silicon layer 13.

FIG. 1 shows further in (b), that the silicon substrate 11 is subsequently removed by thinning using the etch stop layer 12. The etch stop layer 12 is then also removed in this procedure, which exposes the back-side surface of the silicon layer 13. During the thinning process, the intermediate device 10 is provided on a carrier 15 (e.g., carrier wafer).

Finally, FIG. 1 shows in (c), that the back-side semiconductor devices 16 are fabricated on the back-side surface of the silicon layer 13. These back-side semiconductor devices 16 (e.g., back-side logic devices) may be part of the above-mentioned PDN for the front-side logic devices 14.

While fabricating the back-side semiconductor devices 16 in this way is an attractive option, there are also many difficulties. For instance, as also shown in FIG. 1, the technique requires the fabrication of a set of back-side contacts 17 in the silicon layer 13, which are then used to couple to the back-side semiconductor devices 16 and to connect the back-side semiconductor devices 16 to the front-side logic devices 14. These back-side contacts 17 in and at the silicon layer back-side are difficult to build.

For instance, one approach is to define these back-side contacts 17 through the front-side of the silicon layer 13, for instance, by a front-side implantation. This approach may be used as an attempt to circumvent a limit of the thermal budget for the back-side contacts 17. However, at least two problems arise with this approach.

Firstly, any front-side implanted dopants will spread out laterally, hence, they may create a punch-through path that shorts any source and/or drain terminals of the back-side contacts 17. Secondly, the silicon substrate 11 can deform during the thinning process, and also during a later bonding process. This can induce an overlay between the back-side contacts 17 formed by front-side implantation and the back-side semiconductor devices 16. The overlay can again cause a significant deterioration of the source and/or channel series resistances.

### SUMMARY OF THE INVENTION

In view of the above-mentioned challenges and disadvantages, embodiments of this disclosure aim to provide a new approach for fabricating back-side contacts on a back-side of a semiconductor layer. The back-side contacts should be suitable for coupling to one or more back-side semiconductor devices (e.g., back-side logic devices) arranged on the back-side of the semiconductor layer. Further, the back-side contacts should be able to connect the back-side semiconductor devices to one or more front-side logic devices arranged at a front-side of the semiconductor layer. For instance, it should be possible to use the back-side semiconductor devices to be part of a PDN for the front-side logic devices.

An objective is thereby to particularly avoid the above-mentioned disadvantages, which arise from the front-side implantation approach.

These and other objectives are achieved by the embodiments provided in the enclosed independent claims. Advantageous implementations of these embodiments are defined in the dependent claims.

A first aspect of this disclosure provides a semiconductor structure comprising: a semiconductor layer; one or more front-side logic devices, which are at least partly arranged in a front-side of the semiconductor layer; at least four epitaxial layers arranged on a back-side of the semiconductor layer, wherein the four epitaxial layers comprise a first epitaxial layer of a first conductivity type, a second epitaxial layer of a second conductivity type provided directly on the first epitaxial layer, a third epitaxial layer of the second conductivity type provided directly on the second epitaxial layer, and a fourth epitaxial layer of the first conductivity type provided directly on the third epitaxial layer; a plurality of back-side contacts, which are exposed at a back-side surface of the fourth epitaxial layer, wherein the plurality of back-side contacts comprise: a set of first terminal contacts extending into and electrically contacting the fourth epitaxial layer; a set of second terminal contacts extending into and electrically contacting the second epitaxial layer; a set of first gate contacts extending into the third epitaxial layer; and a set of second gate contacts extending into the first epitaxial layer.

The semiconductor structure of the first aspect enables the fabrication of the back-side contacts on the back-side of the semiconductor layer without the necessity of performing a front-side implantation. Accordingly, the above-mentioned disadvantages, which arise from the front-side implantation approach, are avoided. The back-side contacts are further suitable for coupling to back-side semiconductor devices (e.g., back-side logic devices like CMOS devices, or FinFETs, or nanosheet devices like nanosheet FETs), which may be arranged on the back-side of the semiconductor structure to form a new kind of device. Further, the back-side contacts may connect these back-side semiconductor devices to the front-side logic devices.

The semiconductor structure may include more than four epitaxial layers. For instance, the first epitaxial layer to the fourth epitaxial layer may be the rear-most epitaxial layers arranged at the back-side of the semiconductor layer. In addition, for example, a fifth epitaxial layer, or even any further epitaxial layer, may be arranged between the first epitaxial layer and the semiconductor layer. Each of the fifth epitaxial layer or further epitaxial layer may be of the first conductivity type or of the second conductivity type. As described above for the first to fourth epitaxial layers, one or more back-side contacts may also be formed using such a fifth epitaxial layer or further epitaxial layer. For instance, a back-side contact may, respectively, extend into the fifth epitaxial layer or into any further epitaxial layer, and may there contact the epitaxial layer to form a terminal contact, or may be isolated from the epitaxial layer to form a gate contact.

Notably "extending into" in the present disclosure is not the same as "extending through". That is, a back-side contact that extends into a respective epitaxial layer does not extend through that respective epitaxial layer. However, it ends within that respective epitaxial layer. The back-side contact may thereby extend through one or more other epitaxial layers, which are arranged before that respective epitaxial with regard to the extension of the back-side contact. For example, the first gate contacts may extend through the fourth epitaxial layer, the second terminal contacts may extend through the third and the fourth epitaxial layer, and the second gate contacts may extend through the second, the third, and the fourth epitaxial layer.

The first conductivity type may be P-type, and the second conductivity type may be N-type. Alternatively, the first conductivity type may be N-type, and the second conductivity type maybe P-type. The respective first- or second-conductivity- type layers may accordingly be doped with either P-type dopants or N-type dopants. For instance, if the semiconductor layer and/or any epitaxial layer is a silicon layer or silicon-base layer, the P-type dopants may comprise boron, gallium or indium, and the N-type dopants may comprise phosphorus or arsenic. Other examples are possible, and also other material systems that are known in the art. For instance, instead of silicon, gallium arsenide or gallium nitride may be used as semiconductor base material, and N-type and P-type dopants can be chosen as known from the art to form N-type and P-type layers.

A "terminal contact" is electrically connected to the epitaxial layer it extends into. Thus, it may form an Ohmic contact to that epitaxial layer. As explained below in more detail, a terminal contact may be used to implement a source (terminal) or a drain (terminal), for instance, of a MOS device. However, a first terminal contact may also be used to implement a top contact (terminal) connecting the fourth epitaxial layer, and a second terminal contact may also be used to implement a bulk contact (terminal) connecting to the second epitaxial layer.

In an implementation of the semiconductor structure, the set of second terminal contacts is electrically isolated from the third and the fourth epitaxial layer; the set of first gate contacts is electrically isolated from the third and the fourth epitaxial layer; and the set of second gate contacts is electrically isolated from the first, the second, the third, and the fourth epitaxial layer.

A "gate contact" is not electrically connected to the epitaxial layer it extends into. Thus, it may form a MOS contact to that epitaxial layer. As explained below in more detail, a gate contact maybe used to implement a gate, for instance of a MOS device or a dummy gate.

For instance, liners may be used for providing the respective isolations to the epitaxial layers, and/or a dielectric material may be used. A first or second gate contact may be isolated from the epitaxial layer it extends into (e.g., by a gate dielectric), while a first or second terminal contact is electrically connected to the epitaxial layer it extends into. Each back-side contact is isolated from the epitaxial layers it extends through.

In an implementation, the semiconductor structure comprises one or more first-conductivity-type Metal-Oxide-Semiconductor (MOS) devices, wherein each first-conductivity-type MOS device is formed by one first gate contact configured as a first gate of the first-conductivity-type MOS device and two first terminal contacts configured as a first source and first drain of the first-conductivity-type MOS device; and/or one or more second-conductivity-type MOS devices, wherein each second-conductivity-type MOS device is formed by one second gate contact configured as a second gate of the second-conductivity type MOS device and two second terminal contacts configured as a second source and second drain of the second-conductivity-type MOS device.

Thus, one or more back-side MOS devices of the first conductivity type, and one or more MOS devices of the second conductivity type are formed, wherein MOS devices may, in particular, be MOS or CMOS field effect transistors (FETs).

In an implementation of the semiconductor structure, at least one first-conductivity-type MOS device comprises a ring-shaped first gate contact surrounding the first drain and a ring-shaped first source surrounding the ring-shaped first gate contact, in a top-view of the semiconductor structure; and/or at least one second-conductivity-type MOS device comprises a ring-shaped second gate contact surrounding the second drain and a ring-shaped second source surrounding the ring-shaped second gate contact, in a top-view of the semiconductor structure.

Thus, a surrounded drain architecture may be formed for any one of the one or more MOS devices defined on the back-side of the semiconductor structure.

In an implementation, the semiconductor structure further comprises one or more isolation structures, each isolation structure extending into the first epitaxial layer and being either an isolation gate formed by one second gate contacts or a shallow trench isolation (STI).

The isolation structures may, for instance, separate one or more terminal contacts and/or one or more gate contacts from another, or may separate two or more MOS devices from one another. Notably, in this case the second gate contacts have the function of the isolation gates (and may also referred to as "dummy gates", in contrast to "active gates" like the first gate or second gate mentioned above). In the implementation form above, the second gate contacts have the function of the second gates for the second-conductivity type MOS devices (e.g., NMOS gates, if the second-conductivity type is N-type).

In an implementation of the semiconductor structure, each first-conductivity-type MOS device further comprises a first bulk contact formed by one second terminal contact and a first top contact formed by one first terminal contact; and/or each second-conductivity-type MOS device further comprises a second bulk contact formed by one second terminal contact and a second top contact formed by one first terminal contact.

In an implementation, the semiconductor structure comprises a first-conductivity-type MOS device and a second-conductivity-type MOS device, which are separated from each other by at least one of the isolation structures.

In an implementation of the semiconductor structure, the back-side surface of the fourth epitaxial layer is divided into one or more first-conductivity type areas and one or more second-conductivity-type areas by a plurality of intersecting isolation structures, wherein each first-conductivity type area comprises one first-conductivity-type MOS device and each second-conductivity-type area comprises one second-conductivity-type MOS device.

For instance, the different areas (may also referred to as "islands") may be formed and/or separated from each other by a plurality of the isolation structures.

In an implementation of the semiconductor structure, two STIs extend in parallel along a first direction; two isolation gates extend in parallel along a second direction, which is perpendicular to the first direction, and intersect with the two STIs; and a first-conductivity-type area or a second-conductivity-type area is formed within the two STIs and two isolation gates.

In the same way, multiple first- or second-conductivity type areas or islands arranged next to each other (e.g., arranged in rows and/or columns) may be formed on the semiconductor structure back-side.

In an implementation of the semiconductor structure, the fourth epitaxial layer has a higher doping concentration of first conductivity type dopants than the first epitaxial layer; and/or the second epitaxial layer has a higher doping concentration of second conductivity type dopants than the third epitaxial layer.

For instance, the fourth epitaxial layer may be a P+ doped layer, while the first epitaxial layer may be a P- doped layer. The second epitaxial layer may further be an N+ doped layer, while the third epitaxial layer maybe an N- doped layer. N-type and P-type can again be reversed. Doping concentrations for P+, P-, N+, and N-may respectively be 10¹⁹ to 10²¹ *cm*⁻³ for N+ andP+, and 10¹⁶ to 10¹⁹ *cm*⁻³ for N- and P-.

In an implementation of the semiconductor structure, the one or more front-side logic device comprise at least one of a Complementary MOS (CMOS) device (e.g., a FinFET device) and a nanosheet device.

In an implementation of the semiconductor structure, a first gate contact and/or a second gate contact has a triangular tip or a round tip formed, respectively, within the third epitaxial layer and/or the first epitaxial layer.

Thus, different gate shapes can be realized.

In an implementation of the semiconductor structure, each of the at least four epitaxial layers is a silicon layer.

A second aspect of this disclosure provides a method for fabricating a semiconductor structure, the method comprising: forming a semiconductor layer and at least four epitaxial layers on a back-side of the semiconductor layer; forming one or more front-side logic devices, which are at least partly arranged in a front-side of the semiconductor layer; wherein the four epitaxial layers comprise a first epitaxial layer of a first conductivity type, a second epitaxial layer of a second conductivity type provided directly on the first epitaxial layer, a third epitaxial layer of the second conductivity type provided directly on the second epitaxial layer, and a fourth epitaxial layer of the first conductivity type provided directly on the third epitaxial layer; forming a plurality of back-side contacts, which are exposed at a back-side surface of the fourth epitaxial layer, the plurality of back-side contacts comprising a set of first terminal contacts extending into and electrically contacting the fourth epitaxial layer; a set of second terminal contacts extending into and electrically contacting the second epitaxial layer; a set of first gate contacts extending into the third epitaxial layer; and a set of second gate contacts extending into the first epitaxial layer.

In an implementation of the method, forming the semiconductor layer and the at least four epitaxial layers on a back-side of the semiconductor layer comprises: providing a semiconductor substrate; forming an etch stop layer on the semiconductor substrate; forming the four epitaxial layers, starting with the fourth epitaxial layer, on the etch stop layer; forming the semiconductor layer on the first epitaxial layer; thinning the semiconductor substrate to the etch stop layer; and removing the etch stop layer.

This describes an implementation with a dedicated etch stop layer. The etch stop layer maybe a silicon germanium layer, in particular, if the semiconductor layer is a silicon or silicon-based layer. For instance, the etch stop layer may have a thickness in a range of 10-100 nm, in particular, 40-60 nm.

In an implementation of the method, forming the semiconductor layer and the at least four epitaxial layers on a back-side of the semiconductor layer comprises: providing a semiconductor substrate; forming the four epitaxial layers, starting with the fourth epitaxial layer, on the semiconductor substrate; forming the semiconductor layer on the first epitaxial layer; and thinning the semiconductor substrate to the fourth epitaxial layer, which serves as an etch stop layer.

This describes an implementation, in which the fourth epitaxial layer is also an etch stop layer. For instance, the fourth epitaxial layer maybe a silicon germanium layer, in particular, if the semiconductor layer is a silicon layer or silicon-based layer.

In an implementation of the method, each of the at least four epitaxial layers is a silicon layer or silicon-based layer; and/or the etch stop layer, which is formed on the semiconductor substrate, is a silicon germanium layer.

The method of the second aspect achieves the same advantages as the semiconductor structure of the first aspect, and may be extended by respective implementations as described above for the semiconductor structure of the first aspect.

A third aspect of this disclosure provides a device comprising a semiconductor structure according to the first aspect or any of its implementations; and one or more back-side semiconductor devices, which are coupled to the plurality of exposed back-side contacts of the semiconductor structure.

For instance, the back-side semiconductor devices may comprise back-side logic devices (e.g., CMOS devices, FETs, FinFETs, nanosheet devices, or the like). For example, the back-side semiconductor devices may be part of a PDN for the one or more front-side logic devices.

In summary of the above-described aspects and implementations thereof, objectives of the present disclosure are achieved by the at least four stacked epitaxial layers. These epitaxial layers may be in-situ doped epitaxial layers, and maybe doped as follows (from the fourth epitaxial layer to the first epitaxial layer): P+; N-; N+; P- for a P-type semiconductor layer, or N+; P-; P+; N- (i.e., reversed doping types) for an N-type semiconductor layer.

The at least four epitaxial layers can be used to fabricate the back-side contacts, and further to build the first- or second-conductivity type areas, for example, through a network of intersecting trenches that are used to define the various active gates and dummy gates, and/or STIs, and/or the contacts, at different (epitaxial layer) depths.

As an example, as back-side devices in the semiconductor structure, an NMOS source and/or NMOS drain may be formed by second terminal contacts reaching the second epitaxial (N+) layer, while a PMOS source and/or PMOS drain may be formed by first terminal contacts reaching the fourth epitaxial (P+) layer. STIs and NMOS gates may further reach the first epitaxial (P-) layer, while PMOS gates may reach the third epitaxial (N-) layer. Notably, there may be additional gate or terminal contacts in each area, as will be described further below.

### BRIEF DESCRIPTION OF THE DRAWINGS

The above described aspects and implementations are explained in the following description of embodiments with respect to the enclosed drawings:
- FIG. 1: shows a fabrication of a conventional device including front-side logical devices and back-side semiconductor devices.
- FIG. 2: shows a cross-section of a semiconductor structure according to an embodiment of this disclosure, which includes one or more front-side logic devices and a plurality of back-side contacts.
- FIG. 3: shows a top-view of a semiconductor structure according to an embodiment of this disclosure, for example, of the semiconductor structure shown in FIG. 2 and/or the semiconductor structure shown in FIG. 4.
- FIG. 4: shows a cross-section of a semiconductor structure according to an embodiment of this disclosure, which includes one or more front-side logic devices and a plurality of back-side contacts.
- FIG. 5: shows a flow-diagram of a general method according to an embodiment of this disclosure, which may be used to fabricate a semiconductor structure according to an embodiment.
- FIG. 6: shows a step of a detailed method according to an embodiment of this disclosure for fabricating a semiconductor structure according to an embodiment.
- FIG. 7: shows further steps of the detailed method shown in FIG. 6.
- FIG. 8: shows further steps of the detailed method shown in FIG. 6 and in FIG. 7, respectively.
- FIG. 9: shows further steps of the detailed method shown in the FIGs. 6-8.
- FIG. 10: shows a cross-section of a semiconductor structure according to an embodiment of this disclosure, which results from the detailed method shown in the FIGs 6-9.
- FIG. 11: shows a cross-section of a semiconductor structure according to an embodiment of this disclosure, which includes one or more gate contacts with a triangular tip.
- FIG. 12: shows a cross-section of a semiconductor structure according to an embodiment of this disclosure, which has layers of reversed conductivity types.
- FIG. 13: shows a top-view of a semiconductor structure according to an embodiment of this disclosure, which has a surrounded drain architecture.

### DETAILED DESCRIPTION OF EMBODIMENTS OF THE INVENTION

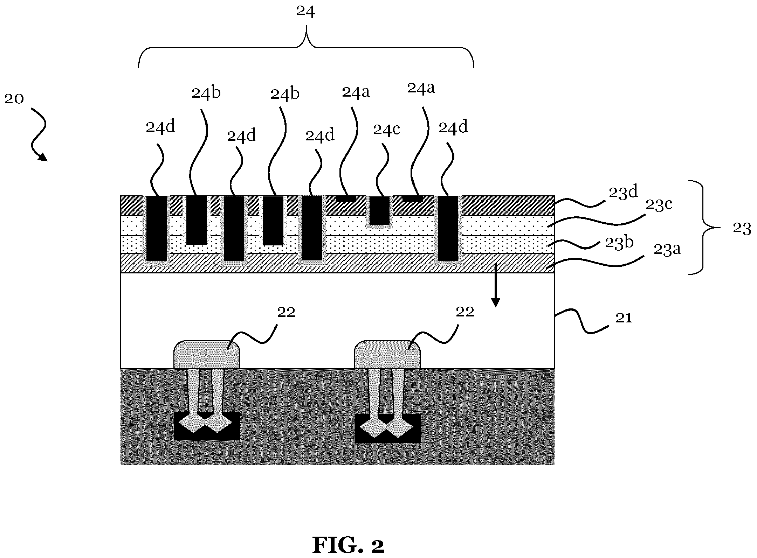

FIG. 2 shows a semiconductor structure 20 according to an embodiment of this disclosure. The semiconductor structure 20 of FIG. 2 includes one or more front-side logic devices 22 and a plurality of back-side contacts 24, which may comprise one or more terminal contacts and one or more gate contacts. The back-side contacts 24 may be configured to couple to semiconductor back-side devices (not shown in FIG. 2), which may be further processed on the semiconductor structure 20 back-side, or which maybe coupled to the semiconductor structure 20 from its back-side. These further semiconductor back-side devices may, for example, be connected via the back-side contacts 24 to the one or more front-side logic devices 22. Further, these semiconductor back-side devices may be part of a PDN for the one or more front-side logic devices 22. The arrow in FIG. 2 indicates that a bias from the back-side to the front-side is possible.

Notably, "back-side" and "front-side" are used as terms relative to each other in this disclosure. Typically, any structures and devices at the front-side are those that are processed first in a semiconductor fabrication process, while any structures and devices at the back-side are those that are processed after the front-side structures and devices, particularly, late in the semiconductor fabrication process.

In particular, the semiconductor structure 20 of FIG. 2 comprises a semiconductor layer 21, which maybe a silicon layer or a silicon-based layer. The semiconductor layer 21 may further be an epitaxial layer (i.e., a layer grown with epitaxy). The semiconductor layer 21 may thereby be of the first conductivity type or of the second conductivity type, i.e., it may be P-doped or N-doped.

The one or more front-side logic devices 22 are at least partly arranged in a front-side of the semiconductor layer 21. As shown in FIG. 2, the front-side logic devise 22 may be provided on a front-side surface of the semiconductor layer 21 - specifically, they may be arranged partly in a dielectric layer that may be provided on the semiconductor layer 21 - and may extend partly into the front-side of the semiconductor layer 21. The front-side logic devices 22 may, for instance, include one or more CMOS devices, and/or one or more FinFET devices, and/or one or more nanosheet devices.

Further, the semiconductor structure 20 comprises at least four epitaxial layers 23 (it may particularly comprise more than four epitaxial layers 23, e.g., five, six or even more such epitaxial layers 23), which are arranged on a back-side of the semiconductor layer 21. These four or more epitaxial layers 23 may be formed in-situ and/or epitaxially. Further, these epitaxial layers 23 may form an epitaxial layer stack, which is arranged on the semiconductor layer 21.

The at least four epitaxial layers 23 specifically comprise a first epitaxial layer 23a of a first conductivity type, a second epitaxial layer 23b of a second conductivity type provided directly on the first epitaxial layer 23a, a third epitaxial layer 23c of the second conductivity type provided directly on the second epitaxial layer 23b, and a fourth epitaxial layer 23d of the first conductivity type provided directly on the third epitaxial layer 23c.

The plurality of back-side contacts 24 are furthermore exposed at a back-side surface of the fourth epitaxial layer 23d, i.e., they are accessible via the back-side surface, and maybe formed in the epitaxial layer stack of the four or more epitaxial layers 23. Thereby, different back-side contacts 24 may extend into different epitaxial layers 23 of the stack (while being isolated from epitaxial layers 23, through which they extend). That means, different back-side contacts 24 may be processed into different depths of the epitaxial layer stack.

The plurality of back-side contacts 24 comprises different types of back-side contacts 24. In particular, the plurality of back-side contacts 24 comprises a set of first terminal contacts 24a, wherein each first terminal contact 24a extends into and electrically contacts the fourth epitaxial layer 23d. Further, the plurality of back-side contacts 24 comprises a set of second terminal contacts 24b, wherein each second terminal contact 24b extends into and electrically contacts the second epitaxial layer 23b. The set of the second terminal contacts 24b may thereby extend through and may be electrically isolated from, respectively, the third epitaxial layer 23c and the fourth epitaxial layer 23d. Notably, a set of terminal contacts 24a or 24b may respectively comprise one or more of the terminal contacts 24a or 24b.

Further, the plurality of back-side devices 24 comprises a set of first gate contacts 24c, where each first gate contact 24c extends into the third epitaxial layer 23c. The set of the first gate contacts 24c may extend through the fourth epitaxial layer 23d, and may be electrically isolated from the third epitaxial layer 23c and the fourth epitaxial layer 23d, respectively. Further, the plurality of back-side devices 24 comprises a set of second gate contacts 24d, wherein each second gate contact 24d extends into the first epitaxial layer 23a. The set of second gate contacts 24d may extend through the second epitaxial layer 23b, the third epitaxial layer 23c, and the fourth epitaxial layer 23d. Further, the set of second gate contacts 24d may be electrically isolated from the first, the second, the third, and the fourth epitaxial layer 23a, 23b, 23c, 23d, respectively. Notably, a set of gate contacts 24c or 24d may respectively comprise one or more of the gate contacts 24c or 24d.

For instance, as an example of the semiconductor structure 20 of FIG. 2, if the first conductivity type is the P-type, the four epitaxial layers 23 may be doped to be respectively P-, N+, N-, P+ layers (from first epitaxial layer 23a to fourth epitaxial layer 23d). If, however, the first conductivity type is N-type, the four epitaxial layers 23 may be doped to be respectively N-, P+, P-, N+ layers (from first epitaxial layer 23a to fourth epitaxial layer 23d). If there are more than four epitaxial layers 23, the above-described doping/layer sequence for the four epitaxial layers 23a-23d may be periodically repeated. That is, for more than four epitaxial layers 23, the layer sequence would be, for example, P-, N+, N-, P+, P-, N+, N-, P+ for eight epitaxial layers (wherein the last four layers P-, N+, N-, P+ are the first epitaxial layer 23a to fourth epitaxial layer 23d), or would be P-, N+, N-, P+, P-, N+, N-, P+, P-, N+, N-, P+ for twelve epitaxial layers (wherein the last four layers P-, N+, N-, P+ are the first epitaxial layer 23a to fourth epitaxial layer 23d), and so on.

Notably, there is no requirement that the number of epitaxial layers 23 is a multiple of four. That is, e.g. according to the above layer (doping) sequences, also five, six, or seven epitaxial layers 23 are possible, wherein in this case four layers of the five or more epitaxial layers 23 are the first epitaxial layer 23a to fourth epitaxial layer 23d (e.g., P-, N+, N-, P+).

Moreover, in any implementation of the at least four epitaxial layers 23, it is also possible that any of the first epitaxial layer 23a to the fourth epitaxial layer 23d has a non-constant or graded doping profile. For example, in this case the doping concentrations for any epitaxial P+, P-, N+, or N- layer may respectively vary within 10¹⁹ to 10²¹ *cm*⁻³ for N+ and P+ layers (for example, in a graded manner), and within 10¹⁶ to 10¹⁹ *cm*⁻³ for N- and P- layers (for example, in a graded manner).

Further, in any implementation of the at least four epitaxial layers, it is also possible that any of the first epitaxial layer 23a to the fourth epitaxial layer 23d comprises a first sublayer having a higher doping concentration and a second sublayer having a lower doping concentration than the first sublayer, wherein the first sublayer is arranged directly on top of the second sublayer, or vice versa. For instance, the second epitaxial layer 23b may comprise a first N- sublayer and a second N+ sublayer, i.e., it maybe referred to as an N-/N+ layer. In this example, the at least four epitaxial layers 23 may form a doping/layer sequence of P-, N-/N+, N-, P+ (from first epitaxial layer 23a to fourth epitaxial layer 23d). With reversed conductivity types, the layer sequence in this example would be N-, P-/P+, P-, N+ (from first epitaxial layer 23a to fourth epitaxial layer 23d). The N-/N+ or P-/P+ layer may reduce a hot carrier effect, band-to-band tunneling, and a parasitic capacitance. The first sublayer and the second sublayer of any epitaxial layer 23 may have different thicknesses. For example, the first sublayer may be thinner than the second sublayer. In the above example of the second epitaxial layer 23b being an N-/N+ (or P-/P+) layer, the first N- (or P-) sublayer may have a thickness of 3-6 nm, while the second N+ (or P+) sublayer has a thickness of 10 nm or larger.

Moreover, each epitaxial P+ layer or P-/P+ layer of the at least four epitaxial layers 23 may define a PMOS level, and each epitaxial N+ layer or N-/N+ layer of the at least for epitaxial layers 23 may define an NMOS level. It is also possible to have a different Vth level (threshold voltage) through a different channel doping in each vertical level of the epitaxial layers 23.

The epitaxial layer stack, in particular, the fourth epitaxial layer 23d, may be exposed at the back-side of the semiconductor structure 20. This may, for instance, be achieved by performing substrate thinning as explained further below. Thus, the back-side contacts 24 may be formed in the four epitaxial layers 23, and may be exposed at the back-side surface of the fourth epitaxial layer 23d.

Each back-side contact 24 may be provided with one of several different functions. For example, one or more PMOS devices and/or NMOS devices may be formed by the back-side contacts 24. Each PMOS or NMOS device may thereby comprise a source, a drain, and a gate. However, the back-side contacts 24 may also be used to form isolation gates, e.g., to be arranged between different MOS devices for isolating those MOS devices from each other.

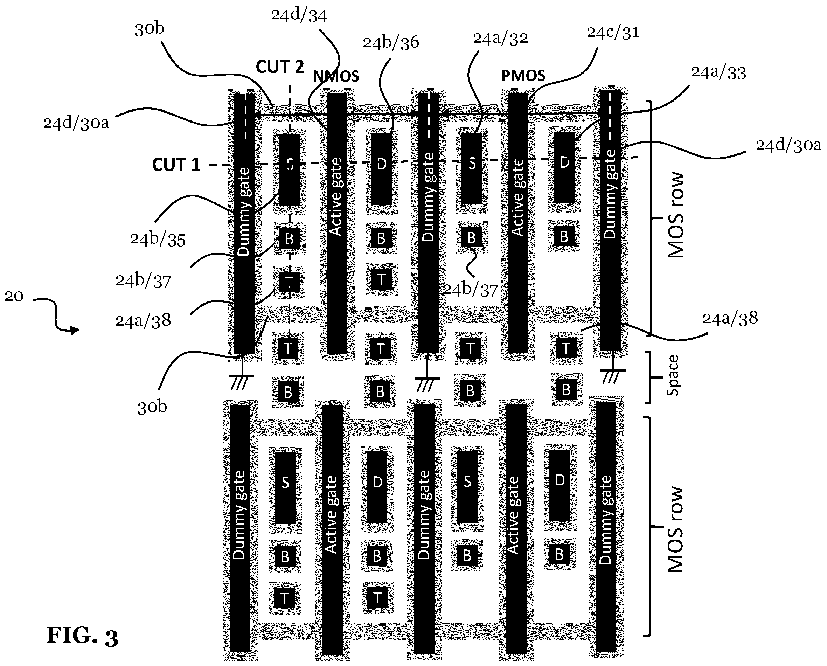

FIG. 3 shows a semiconductor structure 20 according to an embodiment of this disclosure, which builds on the embodiment shown in FIG. 2. Same elements in these figures are labeled with the same reference signs and may be implemented likewise.

In particular, FIG. 3 shows the semiconductor structure 20 in a top-view. FIG. 3 shows specifically that the semiconductor structure 20 may comprise one or more first-conductivity type MOS devices (for example, PMOS devices in this figure), and or one or more second-conductivity MOS devices (for example, NMOS devices in this figure). These MOS devices of the different conductivity types may be arranged in one or more MOS rows and/or in one or more MOS columns. Thereby, adjacent MOS devices may be separated from each other by at least one isolation structure. The semiconductor structure 20 may comprise a plurality of such isolation structures. As shown in FIG. 3, each such an isolation structure may be realized by an isolation gate 30a (also referred to as dummy gate), or by a STI 30b (grey bars in FIG. 3).

In the embodiment of FIG. 3, different rows of MOS devices maybe separated from each other by one or more STIs 30b, and different MOS devices within each row of MOS devices may be separated from each other by at least one dummy gate 30a.

This separation scheme can, however, be adapted or intermixed, so that generally one or more isolation structures 30a and/or 30b maybe used to separate different MOS devices from each other.

Each PMOS device in the embodiment of FIG. 3 is formed by one first gate contact 24c, which is configured as a PMOS gate ("Active gate" in FIG. 2; first gate 31), and further by two first terminal contacts 24a, which are respectively configured as PMOS source ("S" in FIG. 2; first source 32) and PMOS drain ("D" in FIG. 2; first drain 33). Further, each NMOS device is formed by one second gate contact 24d, which is configured as an NMOS gate ("Active gate" in FIG. 2; second gate 34), and is further formed by two second terminal contacts 24b, which are respectively configured as NMOS source ("S" in FIG.2; second source 35) and NMOS drain ("D" in FIG. 2; second drain 36).

Furthermore, each PMOS device may further comprise one or more first bulk contacts 37 ("B" in FIG. 3), each being formed by one second terminal contact 24b. In addition, each PMOS device may comprise one or more first top contacts 38 ("T" in FIG. 2), each being is formed by one first terminal contact 24a. Likewise, each NMOS device may comprises one or more second bulk contacts 37, each being formed by one second terminal contact 24b, and may comprise one or more second top contacts 38, each being formed by one first terminal contact 24a.

Moreover, in the embodiment of FIG. 3, the back-side surface of the semiconductor structure 20 (which is visible in the top-view) may be divided into one or more areas (also referred to as islands), which are separated from each other by the isolating structures 30a and 30b, respectively. Each area may comprise a MOS device, for instance, each first-conductivity type area may comprise one of the PMOS devices and each second-conductivity type area may comprise one of the NMOS devices, or vice versa.

In the embodiment of FIG. 3, as an example, two STIs 30b extend in parallel along a first direction (the horizontal direction in the figure), and two isolation gates 30a extend in parallel along a second direction (the vertical direction in the figure), wherein they intersect with the two STIs 30b. Between these four isolation structures 30a and 30b, a MOS device maybe arranged. For instance, it may be a PMOS device, wherein in this case an NMOS device may be arranged in the neighboring area realized by the two STIS 30b and an additional dummy gate 30a.

In FIG. 3, also two cuts through the semiconductor structure 20 are indicated by dashed lines, namely labelled CUT 1 and CUT 2. Of those, CUT 1 may lead to the cross-section of the semiconductor structure 20 shown in FIG. 2.

That is, also in the semiconductor structure 20 shown in FIG. 2, at least one PMOS source 32 and at least one PMOS drain 33 may be formed by the shown first terminal contacts 24a, which respectively reach the fourth epitaxial layer 23d. Further, at least one PMOS gate 31 may be formed by the shown first gate contact 24c, which reaches the third epitaxial layer 23c and is arranged between the first terminal contacts 24a that may form the PMOS source 32 and the PMOS drain 33. Moreover, at least one NMOS source 35 and at least one NMOS drain 36 may be formed by the shown second terminal contacts 24b, which reach the second epitaxial layer 23b. And consequently, at least one NMOS gate 34 may be formed by one of the shown second gate contact 24d, which reaches the first epitaxial layer 23a and is arranged between the second terminal contacts 24b that may form the NMOS source 35 and NMOS drain 36.

Further in FIG. 2, at least three additional isolation gates 30a may be formed by the shown remaining second gate contacts 24d, wherein each isolation gate 30a extends into the first epitaxial layer 23a. The semiconductor structure 20 of FIG. 2 may also include one or more STIs 30b (not shown in FIG. 2). As shown in FIG. 3, these isolation structures 30a and 30b may intersect each other (e.g., perpendicularly), to define the separated and isolated areas on the back-side surface of the semiconductor structure 20.

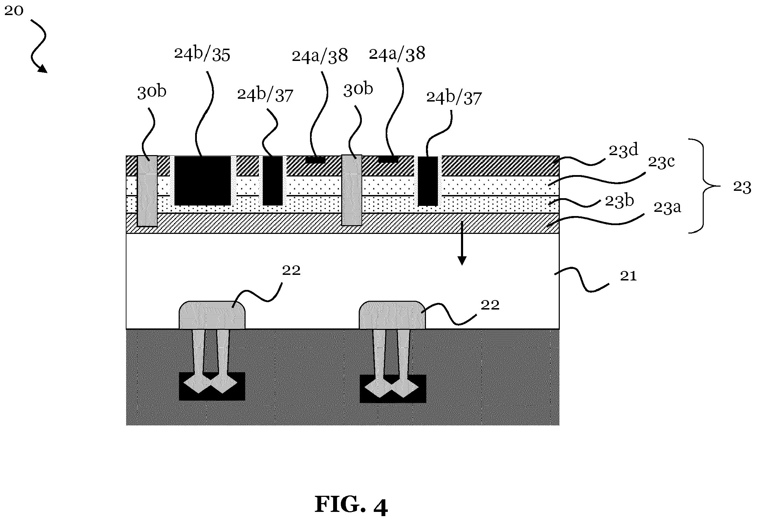

FIG. 4 shows a semiconductor structure 20 according to an embodiment of this disclosure. The semiconductor structure 20 shown in FIG. 4 bases on the semiconductor structures 20 shown, respectively, in FIG. 2 and FIG. 3. Same elements in these figures are labeled with the same reference signs and may be implemented likewise.

Notably, the semiconductor structure 20 of FIG. 4 maybe the same as that shown in FIG. 3. In particular, the CUT 2 shown in FIG. 3 may lead to the cross-section of the semiconductor structure 20 shown in FIG. 4. Therefore, the semiconductor structure 20 of FIG. 4 may also be the same semiconductor structure 20 as shown in FIG. 2, however, different cross-sections (CUT 1 vs. CUT 2 in FIG. 3) are illustrated in this case.

The semiconductor structure 20 of FIG. 4 may comprise again the one or more front-side logic devices 22, which may comprise one or more CMOS devices and/or one or more FinFET devices. Furthermore, the semiconductor structure 20 comprises the at least four epitaxial layers 23, and the various back-side contacts 24 that are fabricated into these four or more epitaxial layers 23.

According to the CUT 2 shown in FIG. 3, the semiconductor structure 20 shown in FIG. 4 includes at least two STIs 30b, at least one NMOS source 35 formed by a second terminal contact 24b, at least two bulk contacts 37 formed each by a second terminal contact 24b, and at least two top contacts 38 formed each by a first terminal contact 24a.

Notably, in the semiconductor structure 20 shown in the FIGs. 2-4, the semiconductor layer 21 may be a doped semiconductor layer, for instance, it may be a P-type or an N-type semiconductor substrate, which may be made of silicon or a silicon-based semiconductor material. Furthermore, the four or more epitaxial layers 23 may comprise two or more P-type epitaxial layers and two or more N-type epitaxial layers. In case of four epitaxial layers 23, there are two P-type epitaxial layers (in particular, P+ and P-) and two N-type epitaxial layers (in particular, N+ and N-).

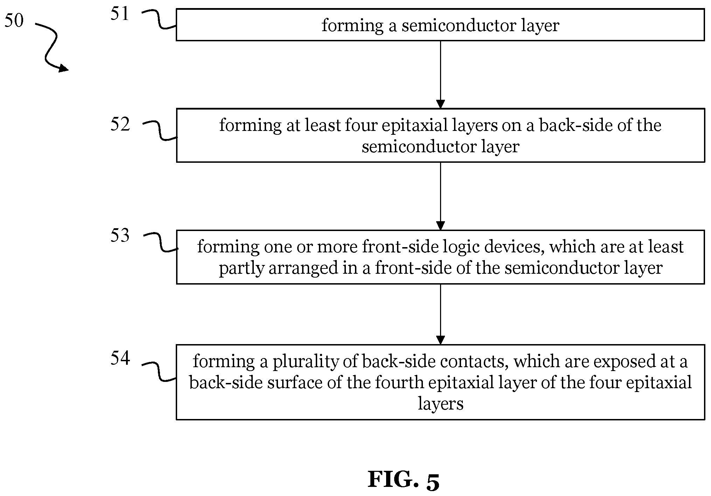

FIG. 5 shows a general method 50 according to an embodiment of this disclosure. The method 50 is suitable for fabricating the semiconductor structure 20 shown and explained in the previous figures.

The method 50 comprises a first step 51 of forming the semiconductor layer 21, for instance, an epitaxial silicon layer or silicon-based layer. Further, the method 50 comprises a second step 52 of forming the at least four epitaxial layers 23 on a back-side of the semiconductor layer 21. In particular, these four epitaxial layers 23 may be realized as shown in FIG. 2 or in FIG. 4. That means, the four epitaxial layers 23 comprise the first epitaxial layer 23a of the first conductivity type, the second epitaxial layer 23b of the second conductivity type, which is formed directly on the first epitaxial layer 23 a, the third epitaxial layer 23c of the second conductivity type, which is formed directly on the second epitaxial layer 23b, and the fourth epitaxial layer 23d of the first conductivity type, which is formed directly on the third epitaxial layer 23c. The method 50 further comprises a step 53 of forming the one or more front-side logic devices 22, for instance, the one or more CMOS devices and/or FinFET devices. These front-side logic devices 22 are at least partly arranged in a front-side of the semiconductor layer 21.

Further, the method 50 comprises a step 54 of forming the plurality of back-side contacts 24, for instance, as shown in the previous FIGs. 2-4. These back-side contacts 24 are exposed at a back-side surface of the fourth epitaxial layer 23d, and comprise the set of first terminal contacts 24a, the set of second terminal contacts 24b, the set of first gate contacts 24c, and the set of second gate contacts 24d, which are described above.

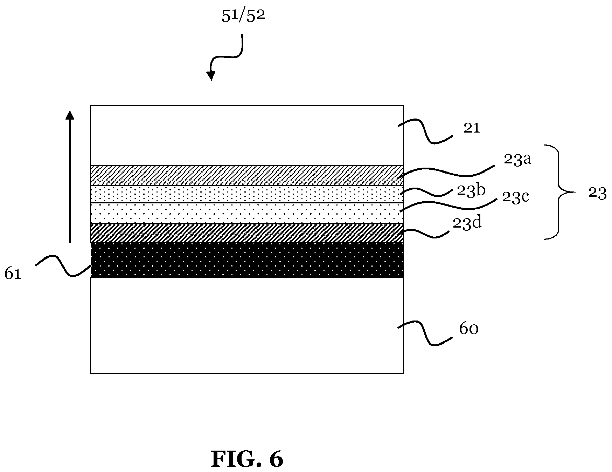

FIGs. 6-9 show a method 50 according to a detailed embodiment of the disclosure, which builds on the method 50 shown in FIG. 5. The method 50 shown in these figures comprises the steps of the method 50 shown in FIG. 5. Same steps and elements in all these figures are labelled with the same reference signs, and may be implemented likewise.

FIG. 6 shows the first two steps 51 and 52 of the method 50. A semiconductor substrate 60 (e.g., a silicon or silicon-based substrate) is provided, and the at least four epitaxial layers 23 and the semiconductor layer 21 are formed on the silicon substrate 60. In particular, as indicated by the direction of fabrication (left-side arrow) in FIG. 6, an etch stop layer 61 may be first formed on the semiconductor substrate 60. Then the four or more epitaxial layers 23 (four layers are exemplarily shown) may be formed directly on the etch stop layer 61.

Thereby, the fourth epitaxial layer 23d is formed first and directly in this case on the etch stop layer 61. Then the third epitaxial layer 23c, the second epitaxial layer 23b, and the first epitaxial layer 23a are formed, in this order and one directly on the other, directly on the fourth epitaxial layer 23d. Subsequently, the semiconductor layer 21 may be formed directly on the first epitaxial layer 23a. If there are more than four epitaxial layers, other epitaxial layers may be formed directly on the first epitaxial layer 23a, and the semiconductor layer 21 may then be formed directly on these other epitaxial layers. The at least four epitaxial layers 23 are formed on a back-side of the semiconductor layer 21, and the exposed upper surface of the semiconductor layer 21 represents, accordingly, the front-side surface of the semiconductor layer 21.

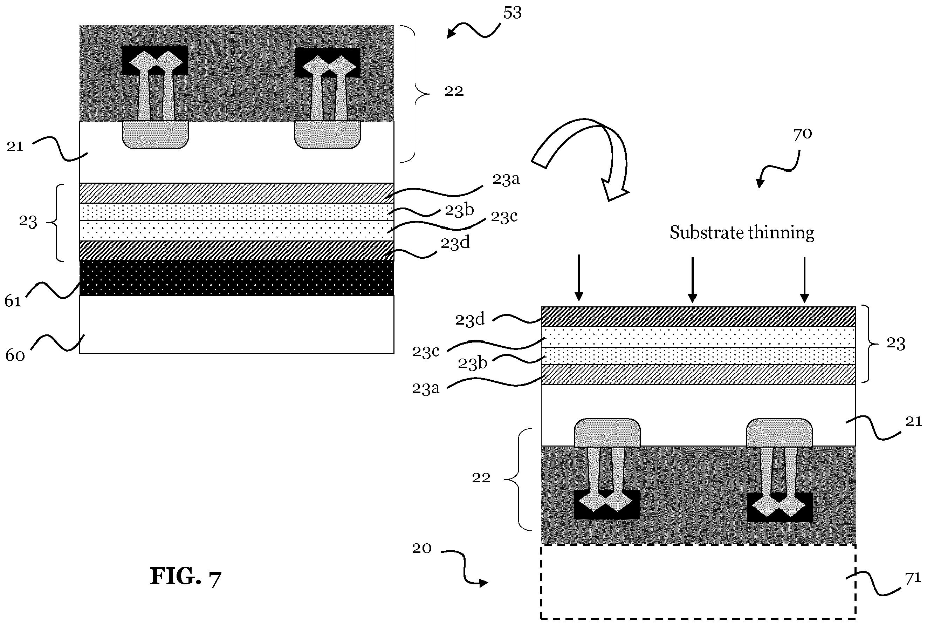

FIG. 7 shows in (a) the step 53 of the method 50, in which the one or more front-side logic devices 22 are fabricated on the front-side of the semiconductor layer 21, as described previously. The one or more front-side logic devices 22 are at least partly arranged in the front-side of the semiconductor layer 21.

FIG. 7 shows then in (b) - notably FIG. 7b is turned upside down compared to FIG. 7a - that a thinning step 70 maybe carried out in the method 50. In particular, the semiconductor substrate 60 may be thinned 70 all the way down to the etch stop layer 61, and the etch stop layer 61 may be removed as well. Notably, it is also possible that there is no dedicated etch stop layer 61 provided. In this case, the fourth epitaxial layer 23d may also act as an etch stop layer during the step of substrate thinning 70. Furthermore, during the substrate thinning 70, the intermediate semiconductor structure may be stabilized on a carrier substrate 71 (e.g., a carrier wafer).

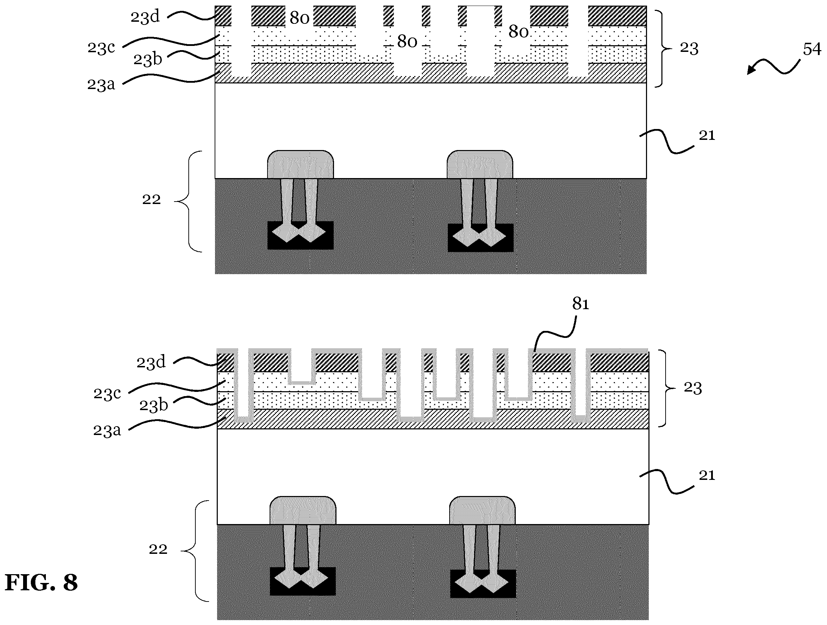

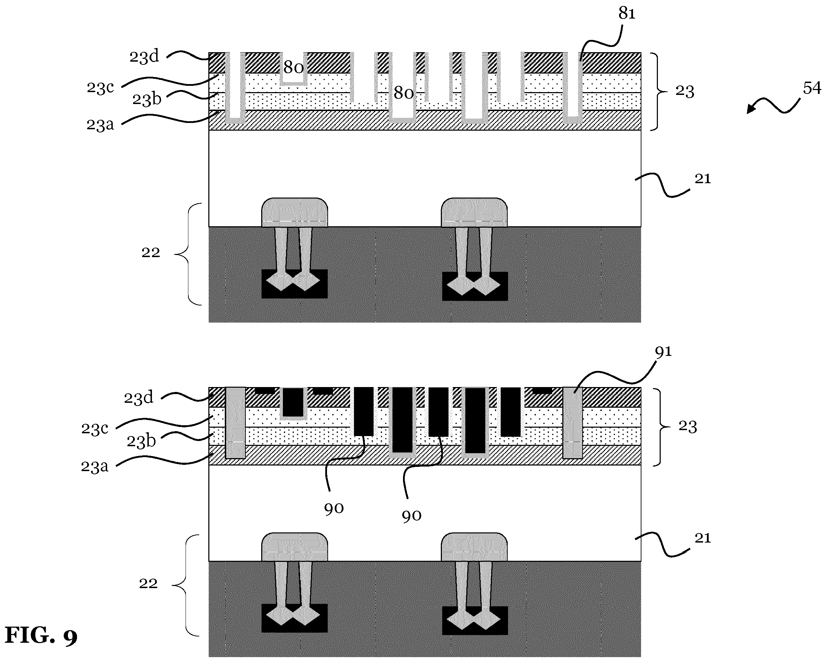

FIG. 8 and FIG. 9 further show details of the step 54 of the method 50, namely, the forming of the plurality of back-side contacts 24. In particular, FIG. 8 shows in (a) that a plurality of trenches 80 (may also be referred to as openings) are etched into the at least four epitaxial layers 23, wherein one trench 80 is related to each back-side contact 24 or STI 30b that is to be formed in the semiconductor structure 20. Accordingly, the trenches 80 may each have a different depth, and may accordingly extend into a different epitaxial layer 23 of the stack. Thereby, the trenches 80 may extend through different epitaxial layers 23 of the stack.

FIG. 8 shows further in (b) that then a dielectric material 81 (or another insulating material) may be deposited onto the surface of the fourth epitaxial layer 23d and into the inner surfaces of the respective trenches 80, which were formed in FIG. 8a. That is, both the sidewall surfaces of the trenches 80 and the bottom surfaces of the trenches 80 may be covered by the deposited material 81.

FIG. 9 shows further in (a) that the deposited material 81 may then be partly removed again, for instance, by etching. In particular, the deposited material 81 may be removed from the top surface of the fourth epitaxial layer 23d, and may also be removed from the bottom surface of all those trenches 80, which relate to first terminal contacts 24a or second terminal contacts 24b, so that later an electric (Ohmic or Schottky) connection is possible to the respective epitaxial layer 23, into which that terminal contact 24a or 24b extends. For those other trenches 80, which relate to a first gate contact 24c or a second gate contact 24d, the deposited material is not removed from the bottom surface of the trench 80, so that a gate contact may be formed in the respective epitaxial layer 23, into which that gate contact 24c or 24d extends (the dielectric material 81 may in this case be used as a gate dielectric). Notably, the dielectric material 81 may also remain on all the sidewalls of the trenches 80, in order to form liners, which may later isolate the back-side contacts 24 of the respective trenches 80 from the epitaxial layers 23, thorough which the back-side contacts 24 extend.

FIG. 9 shows further in (b) that then a contact material 90 may be deposited into each trench 80, which relates to a back-side device 24. This contact material 90 may comprise a metal, like aluminum, copper, tungsten, or the like. Furthermore, a dielectric material 91 may be deposited into each trench 80, which relates to an STI 30b.

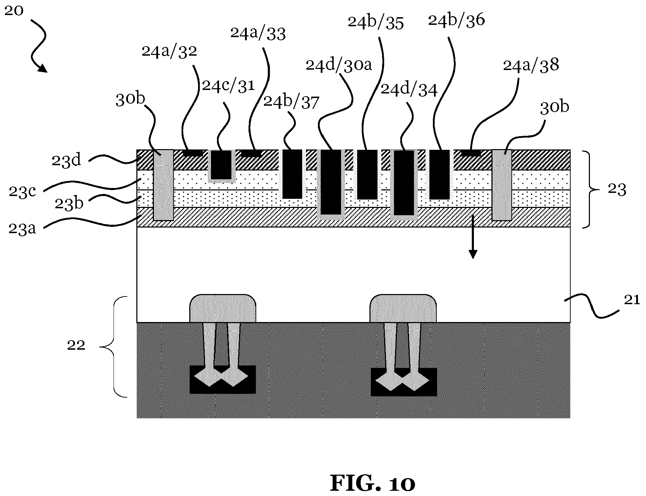

FIG. 10 shows a semiconductor structure 20 according to an embodiment of the invention, which may be obtained by the method 50 shown in the previous FIGs. 6-9. The semiconductor structure 20 bases further on the previously shown semiconductor structures 20, for instance, those of FIGs. 2-4, respectively.

The semiconductor structure 20 of FIG. 10 comprises first terminal contacts 24a, which may form at least one PMOS source 32 and at least one PMOS drain 33, and second terminal contacts 24b, which may form at least one NMOS source 35 and at least one NMOS drain 36. Furthermore, the semiconductor structure 20 comprises at least one first gate contact 24c, which may form at least one PMOS gate 31, and at least one second gate contact 24d, which may form at least one NMOS gate 34. Further, the semiconductor structure 20 may comprise second gate contacts 24d, which may form one or more isolation gates 30a. In addition, the semiconductor structure 20 may also comprise one or more STIs 30b, and at least one top contact 38, which may respectively be formed by first terminal contacts 24a. Further, the semiconductor structure 20 may comprise at least one bulk contact 37, which may be formed by second terminal contacts 24b.

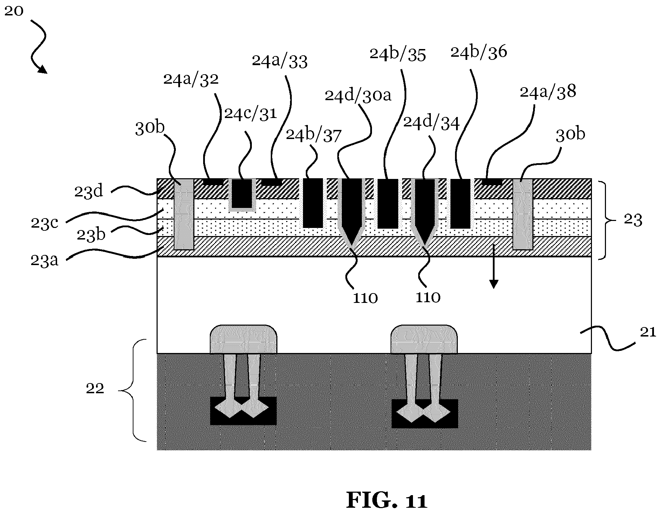

FIG. 11 shows a further semiconductor structure 20 according to an embodiment of the invention, which builds on the embodiment shown in FIG. 10. Same elements in FIG. 10 and FIG. 11 are labelled with the same reference signs and may be implemented likewise.

The difference between FIG. 10 and FIG. 11 is that FIG. 11 shows a version of the semiconductor structure 20, wherein at least the second gate contacts 24d have a triangular tip 110, wherein each triangular tip 110 is respectively formed in the first epitaxial layer 23a. Instead of having a triangular tip 110, these second gate contacts 24d may also have a round tip. Furthermore, it is also possible that the first gate contacts 24c have a triangular tip 110 or a round tip, which is in this case formed in the third epitaxial layer 23c.

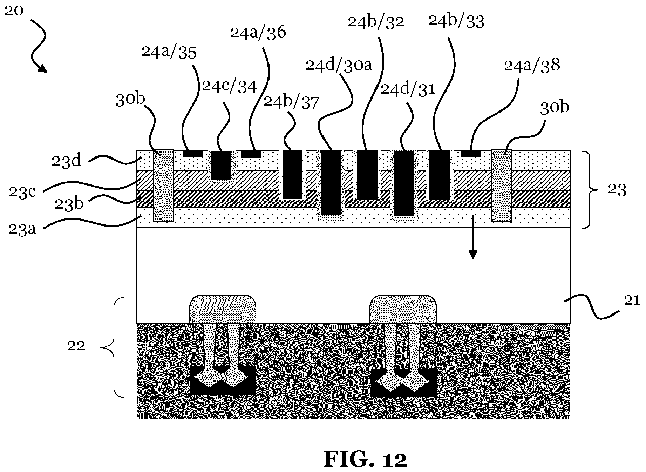

FIG. 12 shows a further semiconductor structure 20 according to an embodiment of this disclosure. In particular, FIG. 12 shows that P-type and N-type may be reversed. That is, while the first conductivity type may be P-type, exemplarily shown in the previous figures, it may now be N-type in the semiconductor structure 20 of FIG. 12 12. Apart from this, the semiconductor structure 20 of FIG. 12 comprises the same features, particularly the same back-side contacts 24 than the semiconductor structure 20 shown in the previous figures. However, also here the conductivity type is switched.

In particular, FIG. 12 shows a PMOS source 35 implemented by a first terminal contact 24a and a PMOS drain 36 implemented by a first terminal contact 24a. Further, it shows a PMOS gate 34 implemented by a first gate contact 24c. Further, it shows an NMOS drain 32 and a NMOS source 33 implemented by second terminal contacts 24b. Further, it shows an NMOS gate 31 implemented by a second gate contact 24d. The semiconductor structure 20 may also comprise top contacts 38 implemented by first terminal contacts 24a, and bulk contacts 37 implemented by second terminal contacts 24b.

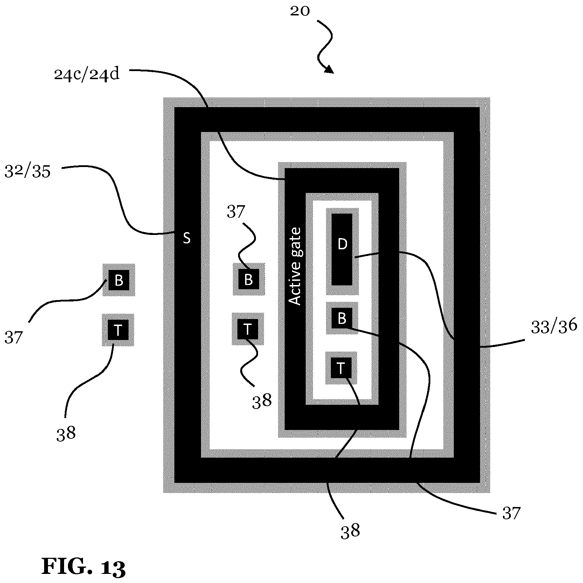

FIG. 13 shows a semiconductor structure 20 in a top-view according to an embodiment of this disclosure. The semiconductor structure 20 bases on the previously shown semiconductor structures 20, and same elements in the figures are again labelled with the same reference signs.

In particular, the semiconductor structure 20 shown in FIG. 13 comprises a ring-shaped first gate contact 24c (could also be a ring-shaped second gate contact 24d), which surrounds a first drain 33 (or a second drain 36). Further, the semiconductor structure 20 comprises a ring-shaped first source 32 (or a ring-shaped second source 35), which surrounds the ring-shaped first gate contact 24c (or ring-shaped second gate contact 24d). As shown in FIG. 13, within the ring-shaped source or ring-shaped gate, there may be arranged further bulk contacts 37 or top contacts 38. By the arrangement shown in FIG. 13, a surrounded drain architecture may be realized.

## Claims

1. A semiconductor structure (20) comprising:
a semiconductor layer (21);
one or more front-side logic devices (22), which are at least partly arranged in a front-side of the semiconductor layer (21);
at least four epitaxial layers (23) arranged on a back-side of the semiconductor layer (21),
wherein the four epitaxial layers (23) comprise a first epitaxial layer (23a) of a first conductivity type, a second epitaxial layer (23b) of a second conductivity type provided directly on the first epitaxial layer (23a), a third epitaxial layer (23c) of the second conductivity type provided directly on the second epitaxial layer (23b), and a fourth epitaxial layer (23d) of the first conductivity type provided directly on the third epitaxial layer (23c);
a plurality of back-side contacts (24), which are exposed at a back-side surface of the fourth epitaxial layer (23d),
wherein the plurality of back-side contacts (24) comprise:
- a set of first terminal contacts (24a) extending into and electrically contacting the fourth epitaxial layer (23d);
- a set of second terminal contacts (24b) extending into and electrically contacting the second epitaxial layer (23b);
- a set of first gate contacts (24c) extending into the third epitaxial layer (23c); and
- a set of second gate contacts (24d) extending into the first epitaxial layer (23a).

2. The semiconductor structure (20) according to claim 1, wherein:
the set of second terminal contacts (24b) is electrically isolated from the third and the fourth epitaxial layer (23c, 23d);
the set of first gate contacts (24c) is electrically isolated from the third and the fourth epitaxial layer (23c, 23d); and
the set of second gate contacts (24d) is electrically isolated from the first, the second, the third, and the fourth epitaxial layer (23a, 23b, 23c, 23d).

3. The semiconductor structure (20) according to claim 1 or 2, comprising:
one or more first-conductivity-type MOS devices, wherein each first-conductivity-type MOS device is formed by one first gate contact (24c) configured as a first gate (31) of the first-conductivity-type MOS device and two first terminal contacts (24a) configured as a first source (32) and first drain (33) of the first-conductivity-type MOS device; and/or
one or more second-conductivity-type MOS devices, wherein each second-conductivity-type MOS device is formed by one second gate contact (24d) configured as a second gate (34) of the second-conductivity type MOS device and two second terminal contacts (24b) configured as a second source (35) and second drain (36) of the second-conductivity-type MOS device.

4. The semiconductor structure (20) according to claim 3, wherein:
at least one first-conductivity-type MOS device comprises a ring-shaped first gate contact (24c) surrounding the first drain (33) and a ring-shaped first source (32) surrounding the ring-shaped first gate contact (24c) , in a top-view of the semiconductor structure (10); and/or
at least one second-conductivity-type MOS device comprises a ring-shaped second gate contact (24d) surrounding the second drain (36) and a ring-shaped second source (35) surrounding the ring-shaped second gate contact (24d), in a top-view of the semiconductor structure (20).

5. The semiconductor structure (20) according to one of the claims 1 to 4, further comprising:
one or more isolation structures (30a, 30b), each isolation structure (30a, 30b) extending into the first epitaxial layer (23a) and being either an isolation gate (30a) formed by one second gate contact (24d) or being a shallow trench isolation, STI (30b).

6. The semiconductor structure (20) according to one of the claims 3 to 5, wherein:
each first-conductivity-type MOS device further comprises a first bulk contact (37) formed by one second terminal contact (24b) and a first top contact (38) formed by one first terminal contact (24a); and/or
each second-conductivity-type MOS device further comprises a second bulk contact (37) formed by one second terminal contact (24b) and a second top contact (38) formed by one first terminal contact(24a).

7. The semiconductor structure (20) according to claim 5 or 6, comprising a first-conductivity-type MOS device and a second-conductivity-type MOS device, which are separated from each other by at least one of the isolation structures (30a, 30b).

8. The semiconductor structure (20) according to one of the claims 5 to 7, wherein the back-side surface of the fourth epitaxial layer (23d) is divided into one or more first-conductivity type areas and one or more second-conductivity-type areas by a plurality of intersecting isolation structures (30a, 30b),
wherein each first-conductivity type area comprises one first-conductivity-type MOS device and each second-conductivity-type area comprises one second-conductivity-type MOS device.

9. The semiconductor structure (20) according to one of the claims 5 to 8, wherein:
two STIs (30b) extend in parallel along a first direction;
two isolation gates (30a) extend in parallel along a second direction, which is perpendicular to the first direction, and intersect with the two STIs (30b); and
a first-conductivity-type area or a second-conductivity-type area is formed within the two STIs (30b) and two isolation gates (30a).

10. The semiconductor structure (20) according to one of the claims 1 to 9, wherein:
the fourth epitaxial layer (23d) has a higher doping concentration of first conductivity type dopants than the first epitaxial layer (23a); and/or
the second epitaxial layer (23b) has a higher doping concentration of second conductivity type dopants than the third epitaxial layer (23c).

11. The semiconductor structure (20) according to one of the claim 1 to 10, wherein the one or more front-side logic device (22) comprise at least one of a CMOS device and a nanosheet device.

12. The semiconductor structure (20) according to one of the claims 1 to 11, wherein a first gate contact (24c) and/or a second gate contact (24d) has a triangular tip or a round tip (110) formed, respectively, within the third epitaxial layer (23c) and/or the first epitaxial layer (23a).

13. A method (50) for fabricating a semiconductor structure (20), the method (50) comprising:
forming (51, 52) a semiconductor layer (21) and at least four epitaxial layers (23) on a back-side of the semiconductor layer (21);
forming (53) one or more front-side logic devices (22), which are at least partly arranged in a front-side of the semiconductor layer (21);
wherein the four epitaxial layers (23) comprise a first epitaxial layer (23a) of a first conductivity type, a second epitaxial layer (23b) of a second conductivity type provided directly on the first epitaxial layer (23a), a third epitaxial layer (23c) of the second conductivity type provided directly on the second epitaxial layer (23b), and a fourth epitaxial layer (23d) of the first conductivity type provided directly on the third epitaxial layer (23c);
forming (54) a plurality of back-side contacts (24), which are exposed at a back-side surface of the fourth epitaxial layer (23d), the plurality of back-side contacts (24) comprising
- a set of first terminal contact (24a) extending into and electrically contacting the fourth epitaxial layer (23d);
- a set of second terminal contact (24b) extending into and electrically contacting the second epitaxial layer (23b);
- a set of first gate contact (24c) extending into the third epitaxial layer (23c); and
- a set of second gate contact (24d) extending into the first epitaxial layer (23a).

14. The method (50) according to claim 13, wherein forming (51, 52) the semiconductor layer (21) and the at least four epitaxial layers (23) on a back-side of the semiconductor layer (21) comprises:
providing a semiconductor substrate (60);
forming an etch stop layer (61) on the semiconductor substrate (60);
forming the four epitaxial layers (23), starting with the fourth epitaxial layer (23d), on the etch stop layer (61);
forming the semiconductor layer (21) on the first epitaxial layer (23a);
thinning (70) the semiconductor substrate (60) to the etch stop layer (61); and
removing the etch stop layer (61).

15. The method (50) according to claim 13, wherein forming (51, 52) the semiconductor layer (21) and the at least four epitaxial layers (23) on a back-side of the semiconductor layer (21) comprises:
providing a semiconductor substrate (60);
forming the four epitaxial layers (23), starting with the fourth epitaxial layer (23d), on the semiconductor substrate (60);
forming the semiconductor layer (21) on the first epitaxial layer (23a); and
thinning (70) the semiconductor substrate (60) to the fourth epitaxial layer (23d), which serves as an etch stop layer.

16. The method (50) according to one of the claims 13 to 15, wherein:
each of the at least four epitaxial layers (23) is a silicon layer; and/or
the etch stop layer (61), which is formed on the semiconductor substrate (60), is a silicon germanium layer.

17. A device comprising:
a semiconductor structure (20) according to one of the claims 1 to 12; and
one or more back-side semiconductor devices, which are coupled to the plurality of exposed back-side contacts (24) of the semiconductor structure (20).
